# FASCICULE DE BREVET EUROPEEN

(11) **EP 0 928 002 B1**
(45) Date de publication et mention de la délivrance du brevet: **20.08.2003**
(21) Numéro de dépôt: 98410155.0
(22) Date de dépôt: 31.12.1998
(51) Int. Cl.: G11C 7/00, G11C 8/00

(54) **Double mémoire pour processeur de signal numérique**
Zweifachspeicher für digitalen Signalprozessor
Dual memory for digital signal processor

(30) Priorité: 31.12.1997 FR 9716869
(43) Date de publication de la demande: 07.07.1999
(73) Titulaire: STMicroelectronics S.A., 92120 Montrouge (FR)
(72) Inventeur: Fuin, Didier, 38660 Lumbin (FR); Curtet, Joel, 38600 Fontaine (FR); Devaux, Fabrice, 38410 Uriage (FR)
(74) Mandataire: de Beaumont, Michel

(56) Documents cités:
- EP-A- 0 507 210
- US-A- 5 175 839
- PATENT ABSTRACTS OF JAPAN vol. 006, no. 258 (P-163), 17 décembre 1982 -& JP 57 152600 A (NIPPON DENKI KK), 20 septembre 1982
- R. S. CAPOWSKI: "Dual Storage System" IBM TECHNICAL DISCLOSURE BULLETIN, vol. 27, no. 1A, juin 1984, page 360 XP000071518 NEW YORK, US

## Description

La présente invention concerne un processeur de signal numérique, plus couramment appelé DSP, et plus particulièrement une organisation de mémoire particulièrement bien adaptée à un DSP.

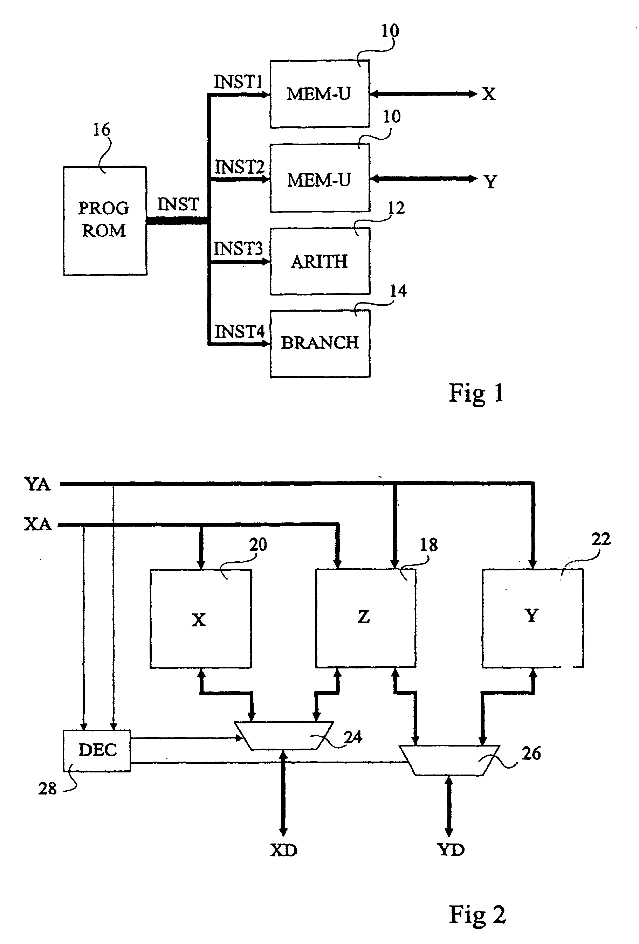

La figure 1 représente schématiquement et partiellement une architecture de DSP classique. Le DSP comprend quatre modules ou unités de traitement fonctionnant en parallèle. Deux de ces modules sont des modules d'accès mémoire 10. Il est par ailleurs prévu un module arithmétique 12 et un module de gestion de branchement 14. Chacun des modules d'accès mémoire 10 est associé à un bus mémoire indépendant X ou Y. Une mémoire de programme 16 contient des instructions composites INST, chaque instruction composite étant en fait composée de quatre instructions simples (INST1-INST4) fournies en même temps aux modules respectifs 10, 12 et 14. Bien entendu, les quatre modules ne sont souvent pas utilisés tous en même temps. Alors, l'instruction complexe fournie par la mémoire 16 comporte des instructions vides (NOP) correspondant aux modules non-utilisés.

Un DSP du type de la figure 1 est optimisé pour effectuer des opérations vectorielles du type x[i] OP y[j], où i et j varient, généralement dans une boucle, et où OP désigne une opération quelconque à effectuer par le module arithmétique 12. En effet, les opérandes x[i] et y[i] peuvent être cherchés en même temps par l'intermédiaire, respectivement, du bus X et du bus Y et traités dans le même cycle par le module arithmétique 12.

Pour ce type d'opération, les valeurs x[i] et les valeurs y[i] peuvent être stockées dans deux mémoires indépendantes connectées respectivement aux bus X et Y.

Toutefois, un DSP peut également être amené à exécuter des opérations du type z[i] OP z[j], les valeurs z étant toutes stockées dans une même mémoire. Dans ce cas, une valeur z, selon le module 10 qui reçoit l'instruction de lecture correspondante, peut être cherchée tantôt par le bus X, tantôt par le bus Y, voire par les deux bus en même temps. Ainsi, on doit pouvoir accéder à une même valeur z par les deux bus X et Y.

Théoriquement on peut utiliser pour cela une mémoire à double accès connectée aux bus X et Y. Toutefois, les mémoires à double accès sont particulièrement coûteuses en surface.

La figure 2 illustre une organisation de mémoire que l'on préfère utiliser compte tenu du fait que le nombre de valeurs que l'on soumet à des opérations du type z[i] OP z[j] est relativement faible. Cette organisation comprend une mémoire à double accès 18 dont la taille est suffisante pour contenir les valeurs de type "z", c'est-à-dire les valeurs qui doivent être accessibles par les deux bus X et Y. Deux mémoires à simple accès 20 et 22 sont respectivement associées aux valeurs de type "x" et aux valeurs de type "y", les valeurs de type "x" étant celles qui ne sont accessibles que par le bus X et les valeurs de type "y" étant celles qui ne sont accessibles que par le bus Y.

Le premier bus d'adresses de la mémoire à double accès 18 et le bus d'adresses de la mémoire à simple accès 20 sont reliés au bus d'adresses XA du bus mémoire X. De façon similaire, le deuxième bus d'adresses de la mémoire à double accès 18 et le bus d'adresses de la mémoire à simple accès 22 sont reliés au bus d'adresses YA du bus mémoire Y. Le premier bus de données de la mémoire 18 et le bus de données de la mémoire 20 sont aiguillés vers le bus de données XD du bus mémoire X par l'intermédiaire d'un multiplexeur/démultiplexeur 24. De façon similaire, le deuxième bus de données de la mémoire 18 et le bus de données de la mémoire 22 sont aiguillés vers le bus de données YD du bus mémoire Y par un multiplexeur/démultiplexeur 26.

Un décodeur 28 commande les multiplexeurs/démultiplexeurs 24 et 26 en fonction des adresses présentées sur les bus XA et YA. En particulier, lorsque l'adresse présente sur le bus XA est dans une plage spécifique, le décodeur 28 commande le multiplexeur/démultiplexeur 24 pour aiguiller le bus XD vers la mémoire 18. En dehors de la plage spécifique, le décodeur 28 aiguille le bus XD vers la mémoire 20. Le même mécanisme est utilisé pour commander le multiplexeur/démultiplexeur 26 en fonction de l'adresse présente sur le bus YA.

Malgré la complexité que représentent les multiplexeurs/démultiplexeurs 24 et 26, la surface occupée par cette organisation mémoire est généralement plus faible que celle occupée par une mémoire à double accès unique regroupant les mémoires 18, 20 et 22, ceci compte tenu du fait que la capacité de la mémoire à double accès 18 est relativement faible.

Les multiplexeurs/démultiplexeurs 24 et 26 accroissent notablement les temps de latence des opérations de lecture et d'écriture dans les mémoires.

Un objet de la présente invention est de prévoir une organisation de mémoire adaptée à un processeur de signal numérique permettant un accès à une même donnée par deux voies distinctes tout en occupant une surface particulièrement faible et n'affectant pas les temps de latence d'accès aux données.

Ces objets sont atteints grâce à un système de traitement de données comprenant un processeur muni de deux modules d'accès mémoire fonctionnant en parallèle ; deux mémoires séparées associées respectivement aux deux modules d'accès ; et des moyens pour, lorsque l'adresse d'une donnée à écrire dans une mémoire est dans une plage prédéterminée, écrire la donnée dans les deux mémoires en même temps à la même adresse.

Selon un mode de réalisation de la présente invention, lesdits moyens comprennent deux instructions d'écriture identiques fournies en même temps aux deux modules d'accès.

Selon un mode de réalisation de la présente invention, lesdits moyens comprennent un premier multiplexeur connecté pour recopier dans un premier module d'accès une instruction d'écriture fournie au deuxième module d'accès lorsque l'adresse d'écriture est dans la plage prédéterminée.

Selon un mode de réalisation de la présente invention, lesdits moyens comprennent un deuxième multiplexeur connecté pour recopier dans le deuxième module d'accès une instruction d'écriture fournie au premier module d'accès lorsque l'adresse d'écriture est dans la plage prédéterminée.

Ces objets, caractéristiques et avantages, ainsi que d'autres de la présente invention seront exposés en détail. dans la description suivante de modes de réalisation particuliers faite à titre non-limitatif en relation avec les figures jointes parmi lesquelles :
la figure 1, précédemment décrite, représente schématiquement et partiellement une architecture mémoire de DSP classique ;
la figure 2 représente schématiquement une organisation mémoire adaptée à un DSP du type de la figure 1 ;
la figure 3 représente schématiquement une organisation mémoire selon la présente invention ;
la figure 4 illustre une solution permettant d'utiliser l'organisation mémoire de la figure 3, dans un cas particulier où on ne souhaite pas modifier le programme d'un DSP classique ; et
la figure 5 illustre une variante de la solution de la figure 4.

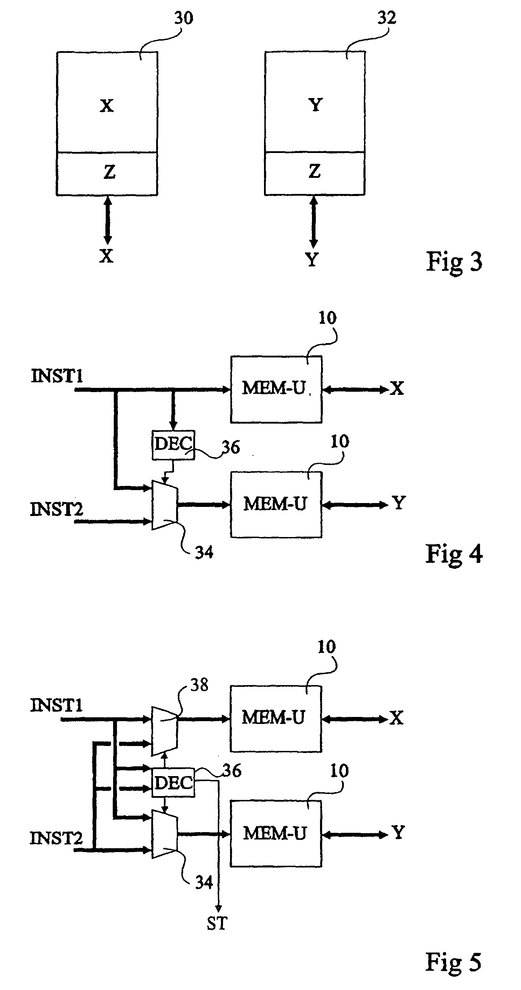

A la figure 3, une organisation mémoire pour un processeur de signal numérique (DSP) du type de la figure 2 comprend seulement deux mémoires à accès simple 30 et 32. Les mémoires 30 et 32 sont connectées respectivement aux bus X et Y du DSP de la figure 1. La mémoire 30 comporte une zone X destinée à stocker les valeurs de type "x", tandis que la mémoire 32 comporte une zone Y destinée à stocker les valeurs de type "y". Ces deux zones correspondent aux mémoires 20 et 22 de l'organisation classique de la figure 2. On rappelle que les valeurs de type "x" ou "y" sont celles auxquelles on accède toujours par le même bus X ou Y.

Selon l'invention, chacune des mémoires 30 et 32 est augmentée d'une zone respective Z de même taille, destinée à contenir les valeurs de type "z", c'est-à-dire les valeurs auxquelles on doit pouvoir accéder tantôt par le bus X, tantôt par le bus Y. Les zones Z des mémoires 30 et 32 sont des recopies exactes l'une de l'autre et sont accessibles par une même plage d'adresses, par exemple les adresses utilisées pour accéder à la mémoire 18 de la figure 2. En d'autres termes, si on accède par le bus X à une valeur dans la zone Z de la mémoire 30, on peut accéder à cette même valeur à la même adresse dans la mémoire 32 par le bus Y.

Bien entendu, pour qu'une telle organisation mémoire fonctionne correctement, il est nécessaire d'assurer que chaque valeur écrite dans la zone Z de la mémoire 30 est également écrite à la même adresse dans la mémoire 32.

Dans une organisation mémoire classique du type de la figure 2, pour écrire une valeur z dans la mémoire 18, il suffisait de fournir une instruction d'écriture à l'un quelconque des modules d'accès 10 du DSP de la figure 1. Si on procède ainsi avec une organisation mémoire du type de la figure 3, la valeur z est écrite dans une seule des mémoires 30 et 32, ce qui n'est pas souhaitable.

Pour éviter cela, une solution avantageuse consiste à modifier les instructions du programme du DSP de manière à toujours fournir aux deux modules d'accès 10 une même instruction d'écriture d'une valeur de type "z". Cette solution ne nécessite aucune modification matérielle du DSP ou de l'organisation mémoire.

La surface occupée par les deux zones Z redondantes est comparable à la surface occupée par la mémoire à double accès 18 de la figure 2. Par contre, on omet les multiplexeurs/démultiplexeurs 24 et 26 et le décodeur 28, ce qui permet une économie de surface notable et une diminution du temps de latence d'accès aux mémoires 30 et 32.

La figure 4 illustre une solution pour écrire une valeur de type "z" dans les deux mémoires 30 et 32 sans modifier le programme du DSP. L'entrée d'instruction du deuxième module d'accès mémoire 10 est précédée d'un multiplexeur 34 permettant de sélectionner l'instruction INST2 fournie à ce module, ou bien l'instruction INST1 fournie au premier module 10. La position du multiplexeur 34 est déterminée par un décodeur 36 en fonction de l'adresse véhiculée en écriture par l'instruction INST1. Si cette adresse correspond à une valeur z, le multiplexeur 34 est positionné pour sélectionner l'instruction INST1. Sinon, il est positionné pour sélectionner l'instruction INST2.

Cette solution nécessite bien entendu une modification du DSP de la figure 1. La surface occupée par le multiplexeur 34 et le décodeur 36 est toutefois relativement faible. Par ailleurs, cette solution suppose que les instructions d'écriture des valeurs z arrivent toujours sur le bus INST1.

La figure 5 illustre une variante de la solution de la figure 4, grâce à laquelle le programmeur ne doit plus se soucier de la position d'une instruction d'écriture d'une valeur de type "z". Un multiplexeur supplémentaire 38, commandé également par le décodeur 36, précède l'entrée d'instruction du premier module d'accès mémoire 10 pour sélectionner l'une ou l'autre des deux instructions INST1 et INST2. Lorsque l'une ou l'autre des instructions INST1 et INST2 est une instruction d'écriture d'une valeur z, le décodeur 36 le détecte et positionne les multiplexeurs 34 et 38 pour dupliquer cette instruction sur les deux modules d'accès mémoire 10.

Un problème se pose lorsqu'arrivent en même temps une instruction d'écriture d'une valeur de type "z" et une autre instruction d'accès mémoire. Il n'est pas possible de les exécuter en même temps par les deux modules 10. Le programmeur du DSP ou le compilateur pourrait veiller à ce que les deux accès soient effectués à des cycles distincts.

Le mode de réalisation de la figure 5 permet toutefois de soulager le programmeur ou le compilateur de cette contrainte. Pour cela, le décodeur 36 est prévu pour détecter la présence sur les bus INST1 et INST2 de deux accès mémoire simultanés dont l'un est une écriture d'une valeur z. Le décodeur 36 active alors un signal ST indiquant une latence d'un cycle, et procède à deux positionnements successifs des multiplexeurs 34 et 38. A la première position, par exemple, les multiplexeurs transmettent aux modules 10 deux copies de l'instruction d'écriture de la valeur z. A la position suivante, les multiplexeurs transmettent l'autre instruction d'accès au module 10 correspondant. De préférence, l'autre module 10 reçoit alors une instruction vide (NOP), mais ceci est difficile à réaliser sans prévoir des circuits supplémentaires. En fait, cet autre module peut recevoir de nouveau l'instruction d'écriture de la valeur z, ce qui entraîne l'écriture deux fois de suite de la même valeur au même emplacement mémoire, c'est-à-dire que l'état de la mémoire reste inchangé.

## Revendications

1. Système de traitement de données comprenant :
- un processeur capable d'exécuter des instructions composites d'accès simultané à deux données et muni à cet effet de deux modules d'accès mémoire (10) fonctionnant en parallèle, chaque module étant commandé par une instruction simple respective contenue dans une telle instruction composite ;
- deux mémoires séparées (30, 32) associées respectivement aux deux modules d'accès ;
**caractérisé en ce qu'**il comprend des moyens pour, lorsqu'une instruction simple d'écriture pour l'un des modules d'accès contient une donnée (z) qui doit être accessible en lecture par l'autre module d'accès, écrire la donnée dans les deux mémoires en même temps à la même adresse.

2. Système selon la revendication 1, **caractérisé en ce que** lesdits moyens comprennent une instruction d'écriture composite à deux instructions simples identiques.

3. Système selon la revendication 2, **caractérisé en ce que** lesdits moyens comprennent un premier multiplexeur (34) connecté pour recopier dans un premier module d'accès (10) une instruction simple d'écriture (INST1) fournie au deuxième module d'accès (10) lorsque l'adresse d'écriture est dans une plage prédéterminée.

4. Système selon la revendication 3, **caractérisé en ce que** lesdits moyens comprennent un deuxième multiplexeur (38) connecté pour recopier dans le deuxième module d'accès (10) une instruction simple d'écriture (INST2) fournie au premier module d'accès (10) lorsque l'adresse d'écriture est dans la plage prédéterminée.

5. Système selon la revendication 4, **caractérisé en ce que** les multiplexeurs sont commandés par un décodeur d'adresses (36) qui analyse les adresses des instructions simples d'écriture contenues dans les instructions d'écriture composites et qui est prévu pour, lorsqu'une première de deux données à écrire doit être accessible par les deux modules d'accès, signaler une latence mémoire d'un cycle au processeur tandis qu'il commande les multiplexeurs pour, en deux cycles consécutifs, présenter l'instruction simple d'écriture de la première donnée aux deux modules d'accès et présenter l'instruction d'écriture simple de l'autre donnée au module correspondant.

## Patentansprüche

1. Datenverarbeitungssystem, das folgendes aufweist:
einen Prozessor, der zusammengesetzte Anweisungen ausführen kann für einen simultanen Zugriff auf zwei Daten bzw. Datensätze und zu diesem Zweck versehen ist mit zwei Speicherzugriffseinheiten (10), die parallel arbeiten, wobei jede Einheit gesteuert wird durch eine jeweilige Einfachanweisung, die in einer besagten zusammengesetzten Anweisung enthalten ist;
zwei getrennte Speicher (30, 32), die jeweils den zwei Zugriffseinheiten zugeordnet sind;
**dadurch gekennzeichnet, dass** es Mittel aufweist für ein Schreiben der Daten in beide Speicher zur gleichen Zeit bei der gleichen Adresse, wenn eine einfache Schreibanweisung für eine der Zugriffseinheiten einen Datensatz (z) enthält, der für ein Lesen zugreifbar sein sollte durch das andere Zugriffsmodul.

2. System nach Anspruch 1, **dadurch gekennzeichnet, dass** die Mittel eine zusammengesetzte Schreibanweisung mit zwei identischen Einfachanweisungen aufweist.

3. System nach Anspruch 2, **dadurch gekennzeichnet, dass** die Mittel einen ersten Multiplexer (34) verbunden für ein Kopieren in eine erste Zugriffseinheit (10) einer einfachen Schreibanweisung (INST1), die an die zweite Zugriffseinheit (10) geliefert wird, wenn die Schreibadresse in einem vorbestimmten Bereich ist.

4. System nach Anspruch 3, **dadurch gekennzeichnet, dass** die Mittel einen zweiten Multiplexer (38) aufweisen, der verbunden ist für ein Kopieren in die zweite Zugriffseinheit (10) einer einfachen Schreibanweisung (INST2), die an die erste Zugriffseinheit (10) geliefert wird, wenn die Schreibadresse in einem vorbestimmten Bereich ist.

5. System nach Anspruch 4, **dadurch gekennzeichnet, dass** die Multiplexer gesteuert werden durch einen Adressendecodierer (36), der die Adressen der einfachen Schreibanweisungen analysiert, die in den zusammengesetzten Schreibanweisungen enthalten sind, und der angepasst ist für das Signalisieren eines Speicherwartezyklus an den Prozessor während er die Multiplexer in zwei aufeinanderfolgenden Zyklen steuert für das Präsentieren der einfachen Schreibanweisung des ersten Datensatzes an die zwei Zugriffseinheiten und das Präsentieren der einfachen Schreibanweisung des anderen Datensatzes an die entsprechende Einheit, wenn ein erster von zwei zu schreibenden Datensätzen zugreifbar sein sollte durch die zwei Zugriffseinheiten.

## Claims

1. A data processing system comprising:
a processor capable of executing composite instructions for simultaneous access to two data and provided for this purpose with two memory access units (10) operating in parallel, each unit being controlled by a respective simple instruction contained in such a composite instruction;
two separate memories (30, 32) respectively associated with the two access units;
**characterized in that** it comprises means for, when a simple write instruction for one of the access units contains a data (z) which should be read accessible by the other access module, writing the data in both memories at the same time at the same address.

2. The system of claim 1, **characterized in that** said means comprise one composite write instruction having two identical simple instructions.

3. The system of claim 2, **characterized in that** said means comprise a first multiplexer (34) connected to copy in a first access unit (10) a simple write instruction (INST1) provided to the second access unit (10) when the write address is in a predetermined range.

4. The system of claim 3, **characterized in that** said means comprise a second multiplexer (38) connected to copy into the second access unit (10) a simple write instruction (INST2) provided to the first access unit (10) when the write address is in the predetermined range.

5. The system of claim 4, **characterized in that** the multiplexers are controlled by an address decoder (36) that analyzes the addresses of the simple write instructions contained in the composite write instructions and that is adapted, when a first of two data to be written should be accessible by the two access units, signaling one memory latency cycle to the processor while it controls the multiplexers for, in two consecutive cycles, presenting the simple write instruction of the first data to the two access units and presenting the simple write instruction of the other data to the corresponding unit.
